# DEMANDE DE BREVET EUROPEEN

(11) **EP 2 535 924 A1**
(43) Date de publication de la demande: **19.12.2012**
(21) Numéro de dépôt: 12305687.1
(22) Date de dépôt: 16.06.2012
(51) Int. Cl.: H01L 21/762, H01L 29/423

(54) **Circuit integre comprenant une tranchée d'isolement et procédé correspondant**

(30) Priorité: 16.06.2011 FR 1155248
(71) Demandeur: STMicroelectronics (Crolles 2) SAS, 38920 Crolles (FR)
(72) Inventeur: Bidal, Grégory, 38000 Grenoble (FR); Favennec, Laurent, 38700 La tronche (FR); Bianchi, Raul Andres, 73800 Myans (FR)
(74) Mandataire: Palix, Stéphane

(57) **Abrégé**

L'invention concerne un circuit intégré comprenant au moins une tranchée d'isolement (40) délimitant une zone active en matériau semiconducteur monocristallin, la ou chaque tranchée comprenant une portion supérieure (44) comportant une couche isolante d'encapsulation d'une portion inférieure (42) de la tranchée, la portion inférieure étant au moins en partie enterrée dans la zone active, la couche d'encapsulation comprenant de l'azote ou du carbone.

## Description

### Domaine de l'invention

La présente invention concerne le domaine des circuits intégrés. Elle concerne plus particulièrement les circuits intégrés comprenant des tranchées d'isolement délimitant chacune une zone active en matériau semi-conducteur ainsi que leur procédé de fabrication correspondant.

### Exposé de l'art antérieur

Il est connu de réaliser des transistors MOS à diélectrique de grille à haute permittivité. Il est également connu d'intégrer dans une grille d'un tel transistor MOS une couche configurée pour ajuster le travail de sortie de la grille.

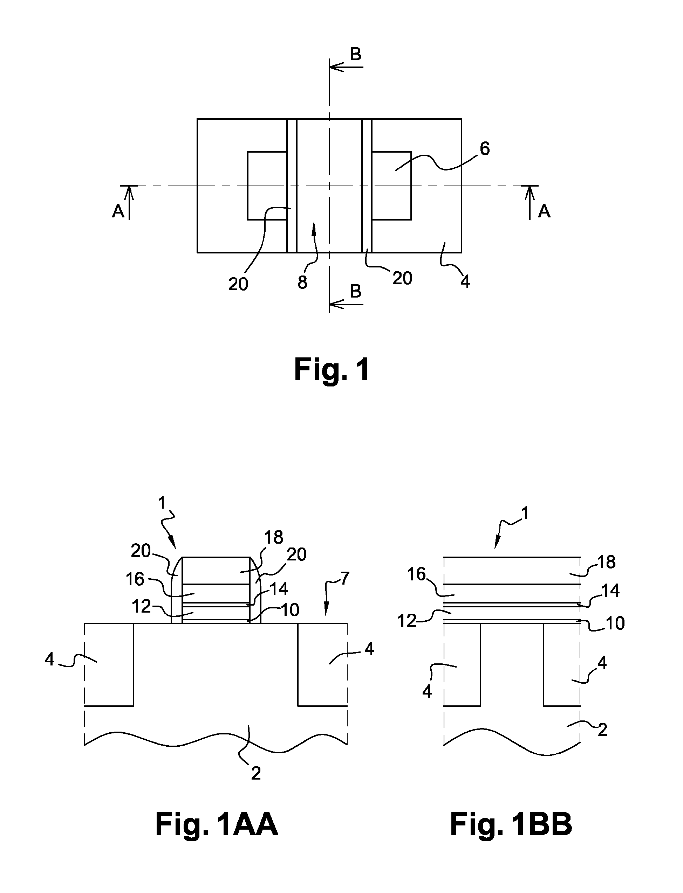

Les figures 1, 1AA, 1BB sont respectivement une vue de dessus, une vue en coupe selon le plan AA de la figure 1 et une vue en coupe selon le plan BB de la figure 1 d'un transistor MOS 1 réalisé sur et dans une portion d'un substrat 2 semi-conducteur.

Le substrat 2 comprend une tranchée d'isolement 4, couramment appelée STI (de l'anglais Shallow Trench Isolation) délimitant une zone active 6 en silicium monocristallin. Sur la face avant 7 du substrat 2 est disposée une grille 8 isolée du substrat par une couche isolante d'interface 10 en oxyde de silicium. La grille 8 comprend successivement une couche diélectrique 12 à haute permittivité en oxyde d'hafnium disposée sur la couche 10, une couche 14 en lanthane ou en magnésium adaptée pour ajuster le travail de sortie de la grille, une couche métallique 16 en nitrure de titane et enfin une couche 18 en silicium polycristallin. Deux espaceurs 20 sont disposés de part et d'autre de la grille 8.

Par souci de simplification, les zones de source et de drain du transistor 1 ne sont pas représentées.

Une fois la couche 14 formée, le lanthane présent dans cette couche 14 a tendance à diffuser à chacune des étapes suivantes nécessitant un certain budget thermique. La Demanderesse a notamment noté la présence du phénomène de diffusion à une température supérieure à 500°C. Le lanthane a tendance à être absorbé par des réservoirs d'oxygène de manière à former des composés du type La₂O₃ ou silicate de Lanthane. La concentration en lanthane dans la couche 14 diminue de façon non contrôlée. Cette couche ne peut donc plus jouer son rôle : l'ajustement du travail de sortie de la grille est faussé. Or, la tension de seuil d'un transistor MOS étant proportionnel notamment au travail de sortie de la grille, les caractéristiques de fonctionnement du transistor sont modifiées et ne sont plus contrôlées.

Il en est de même si la couche 14 comprend du magnésium à la place du lanthane. Le magnésium diffuse et recherche des réservoirs d'oxygène de manière à former des composés du type MgO.

La Demanderesse a également constaté le même phénomène de recherche d'oxygène lorsque le lanthane et le magnésium sont respectivement déposés sous forme de La₂O₃ et de MgO.

### Résumé

Un objet d'un mode de réalisation de la présente invention est de prévoir un circuit intégré comprenant une tranchée d'isolement évitant au moins certains des inconvénients des circuits intégrés antérieurs.

Un objet plus particulier d'un mode de réalisation de la présente invention est de prévoir un circuit intégré comprenant des transistors MOS dont le travail de sortie de la grille est contrôlé.

Un autre objet d'un mode de réalisation de la présente invention est de prévoir un procédé de fabrication d'un circuit intégré palliant au moins certains des inconvénients des procédés de fabrication antérieurs.

Ainsi, un mode de réalisation de la présente invention prévoit un circuit intégré comprenant au moins une tranchée d'isolement délimitant une zone active en matériau semi-conducteur monocristallin, comprenant en outre au moins une grille de transistor MOS isolé de la zone active par une couche d'isolation de grille sur laquelle est disposée une couche comprenant du lanthane, du magnésium, de l'aluminium ou du dysprosium, configurée pour ajuster le travail de sortie de la grille et une couche métallique, la ou chaque tranchée comprenant une portion supérieure comportant une couche isolante d'encapsulation d'une portion inférieure de la tranchée, la portion inférieure étant au moins en partie enterrée dans la zone active, la couche d'encapsulation comprenant de l'azote ou du carbone.

Selon un autre mode de réalisation, la couche d'encapsulation comprend de l'oxynitrure de silicium ou du nitrure de silicium.

Selon un autre mode de réalisation, la couche d'encapsulation comprend de l'oxycarbure de silicium ou du carbure de silicium.

Selon un autre mode de réalisation, la couche d'encapsulation comprend deux éléments en saillie disposés en périphérie de la couche.

Un mode de réalisation de la présente invention prévoit également un procédé de fabrication d'un circuit intégré dans un substrat semi-conducteur monocristallin, comprenant en outre au moins une grille de transistor MOS isolé de la zone active par une couche d'isolation de grille, sur laquelle est disposée une couche comprenant du lanthane, du magnésium, de l'aluminium ou du dysprosium, configurée pour ajuster le travail de sortie de la grille et une couche métallique, comprenant les étapes suivantes :
- former dans le substrat au moins une portion inférieure d'une tranchée d'isolement délimitant une zone active;
- former une couche isolante d'encapsulation comprenant de l'azote ou du carbone, la couche isolante définissant une portion supérieure de la tranchée d'isolement.

Selon un autre mode de réalisation, le procédé comprend en outre les étapes successives suivantes :
- former une couche d'isolation de grille;
- former une couche configurée pour ajuster le travail de sortie de la grille ;
- former une couche en matériau conducteur ;

Selon un autre mode de réalisation, le procédé comprend en outre l'étape suivante :
- former des zones de source et de drain de part et d'autre de la grille.

Selon un autre mode de réalisation, la couche isolante d'encapsulation est formée suite aux étapes suivantes :
- déposer une couche comprenant de l'azote ou du carbone;
- réaliser une photolithographie ;
- réaliser une gravure partielle de la couche comprenant de l'azote ou du carbone.

Selon un autre mode de réalisation, la couche isolante d'encapsulation est formée suite à une étape d'implantation ionique d'azote ou de carbone.

Selon un autre mode de réalisation, la formation de la couche isolante d'encapsulation de la tranchée d'isolement comprend les étapes suivantes :
- former la couche d'encapsulation par un dépôt conforme d'une couche comprenant de l'azote ou du carbone;
- former une couche isolante par un dépôt sur la couche d'encapsulation ;
- graver entièrement la couche isolante et la couche d'encapsulation de sorte qu'une partie de la couche d'encapsulation recouvre la portion inférieure de la tranchée.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1, 1AA, 1BB, précédemment décrites, sont respectivement une vue de dessus, une vue en coupe selon le plan AA de la figure 1 et une vue en coupe selon le plan BB de la figure 1 d'un transistor MOS ;
la figure 2 est une vue en coupe d'une tranchée d'isolement selon un mode de réalisation de l'invention ;
la figure 3 est une vue en coupe d'une tranchée d'isolement selon un autre mode de réalisation de l'invention ;
les figures 4A à 4F sont des vues en coupe illustrant les étapes d'un procédé de fabrication d'une tranchée d'isolement selon un mode réalisation de l'invention ;
la figure 4G est une vue en coupe suivant le plan BB d'une tranchée d'isolement séparant deux transistors MOS distincts selon un mode réalisation de l'invention ;
la figure 5 est une vue en coupe d'un circuit intégré selon un mode réalisation de l'invention.

### Description détaillée

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

Sur les figures 1, 1AA et 1BB, on note la présence d'au moins trois réservoirs d'oxygène. Les espaceurs en dioxyde de silicium constituent un premier réservoir d'oxygène. Lors d'une étape postérieure à la formation de la grille 8 et des espaceurs 20 nécessitant un budget thermique, le lanthane ou le magnésium de la couche 14 diffuse naturellement vers les espaceurs. Les espaceurs 20 étant en contact direct avec la couche 14, ce phénomène de diffusion est accentué. Pour pallier cet inconvénient, les espaceurs sont avantageusement réalisés en nitrure de silicium.

De la même manière, la couche isolante d'interface 10 réalisée en dioxyde de silicium constitue un deuxième réservoir d'oxygène. Pour atténuer la diffusion du lanthane ou du magnésium de la couche 14 dans la couche 10, on forme avantageusement une couche isolante d'interface comprenant un composant du type SiOₓN₁₋ₓ. x est de préférence compris entre 0.1 et 0.5, avantageusement entre 0.1 et 0.2.

Un troisième réservoir possible d'oxygène est constitué de la tranchée d'isolement 4 formée en dioxyde de silicium. Comme représenté en figure 1BB, la couche 14 est disposée en partie au-dessus de la tranchée 4. Cela facilite la diffusion du lanthane ou du magnésium vers la tranchée 4.

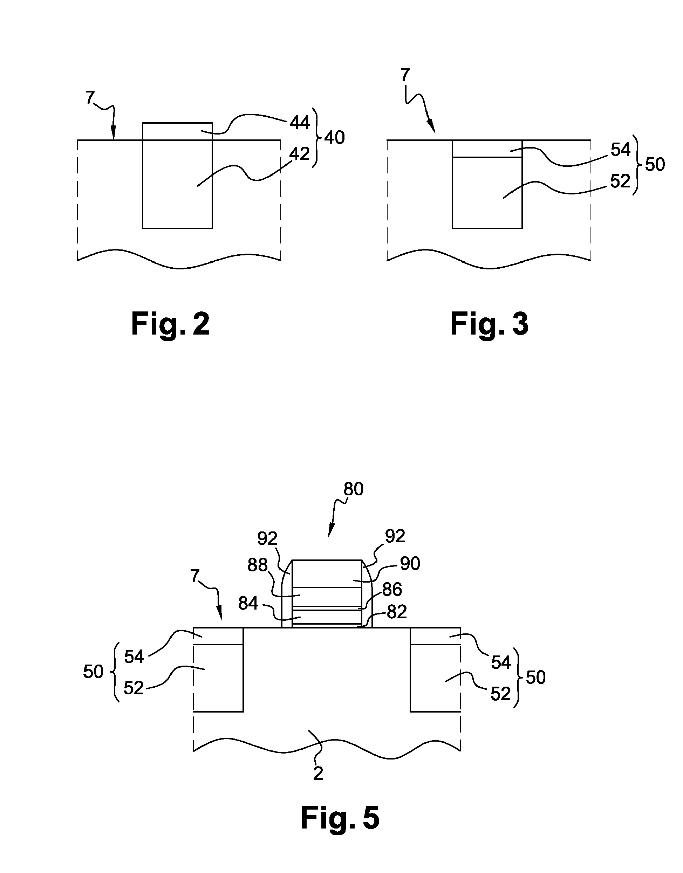

La figure 2 est une vue en coupe d'une tranchée d'isolement 40 disposée dans le substrat 2 en matériau semi-conducteur avantageusement monocristallin, par exemple du silicium.

La tranchée 40 comprend une portion inférieure 42 et une portion supérieure 44. Sur la portion inférieure 42, par exemple en dioxyde de silicium, à savoir du côté de la face avant 7 du substrat 2, est disposée une couche isolante d'encapsulation de la tranchée, la couche isolante formant la portion supérieure 44. Sur la figure 2, la portion inférieure est enterrée dans le substrat. On peut prévoir que cette portion 42 ne soit enterrée que partiellement. En d'autres termes, une partie de la portion 42 peut être en saillie par rapport au substrat.

La Demanderesse a noté que la présence d'azote ou de carbone dans la couche 44 ralentit la diffusion du lanthane ou du magnésium présent dans la grille vers le réservoir d'oxygène constitué par la portion 42. La présence d'azote ou de carbone dans la couche 44 permet à cette couche de jouer le rôle d'un écran entre la grille et la portion 42. L'écran minimise l'absorption du lanthane ou du magnésium par la portion 42 de la tranchée 40. A titre d'exemple, la couche 44 comprend de l'oxynitrure de silicium (SiON) ou de l'oxycarbure de silicium (SiOC). Plus la concentration en azote (respectivement en carbone) augmente, plus l'écran est efficace. Avantageusement, la couche 44 comprend du nitrure de silicium SiN (respectivement du carbure de silicium SiC). La couche 44 a une épaisseur comprise entre 1 et 100 nm, de préférence entre 2 et 10 nm.

A titre d'exemple, le procédé de formation de la couche 44 est le suivant. On forme la portion inférieure 42 de la tranchée d'isolement 40 dans le substrat 2 par une étape de photolithographie puis une étape de gravure suivie d'une étape de dépôt de SiO₂ de type CVD (pour « Chemical Vapour Deposition »). On dépose ensuite une couche isolante comprenant de l'azote (ou du carbone) sur l'intégralité de la face avant 7 du substrat 2. Le dépôt peut être de type CVD. Avantageusement, le dépôt peut être de type LPCVD (pour « Low Pressure Chemical Vapour Deposition ») ou de type RTCVD (pour « Rapid Thermal Chemical Vapor Deposition »). On réalise ensuite une étape de photolithographie puis une étape de gravure de manière à ne laisser que la partie de la couche isolante au niveau de la portion inférieure 42 de la tranchée d'isolement 40. On a formé ainsi la couche isolante 44 d'encapsulation.

Cet exemple de procédé entraîne l'utilisation d'une résine de polarité complémentaire par rapport à la résine utilisée pour la réalisation de la portion inférieure de la tranchée 40. Cette résine est peu adaptée à un environnement de salle blanche. En variante, on peut également prévoir l'utilisation d'un deuxième masque complémentaire (par rapport à un premier masque utilisé pour la formation de la portion 42), ce qui entraîne un coût supplémentaire. On peut également noter l'existence éventuelle d'un problème d'alignement avec la portion 42.

Avantageusement, la Demanderesse propose la structure suivante.

La figure 3 est une vue en coupe d'une tranchée d'isolement 50 disposée dans le substrat 2.

La tranchée 50 comprend une portion inférieure 52 et une portion supérieure 54. La portion inférieure est enterrée dans le substrat. La portion 54 comprend une couche isolante d'encapsulation. On note que la surface supérieure de la couche d'encapsulation 54 affleure sensiblement la surface supérieure de la face avant 7. En variante, on peut prévoir que la surface supérieure de la tranchée 50 soit en retrait ou en saillie par rapport à la surface supérieure de la face avant 7 du substrat 2.

La portion inférieure 52 comprend par exemple du dioxyde de silicium. La couche 54 comprend de l'azote (ou du carbone). Elle peut comprendre un composé du type SiON (ou du type SiOC). Elle est avantageusement en nitrure de silicium (ou en SiC). La couche 54 a une épaisseur comprise entre 1 et 100 nm, de préférence entre 2 et 10nm. La présence d'azote (ou de carbone) dans la couche 54 limite la diffusion du lanthane ou du magnésium vers le réservoir d'oxygène, à savoir vers la portion inférieure 52.

Un exemple de procédé de réalisation de la couche 54 est le suivant. On forme la tranchée d'isolement dans le substrat 2 (de la même manière que la portion 42). Après une étape de photolithographie, on définit une ouverture au niveau de la tranchée. On réalise ensuite une étape d'implantation ionique d'azote dans le dioxyde de silicium composant la tranchée. L'énergie d'implantation et la dose de dopants sont choisies de manière à former la couche 54, en surface, dans la portion supérieure de la tranchée. La couche 54 constitue alors un écran empêchant le lanthane ou le magnésium d'être absorbé dans la portion inférieure 52 de la tranchée 50 constituant le réservoir d'oxygène.

Lors de l'étape de photolithographie, il peut éventuellement apparaître un problème d'alignement de la résine par rapport à la portion 52. De plus, l'implantation ionique peut éventuellement entraîner un endommagement de la zone active.

Pour améliorer les procédés précédemment décrits, la Demanderesse propose le procédé suivant.

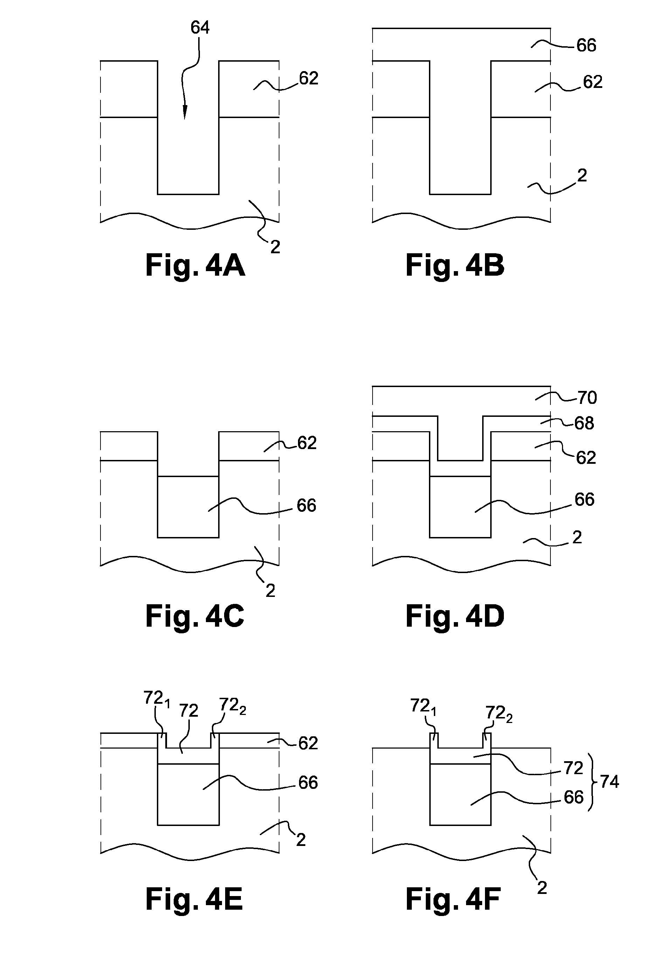

Les figures 4A à 4F sont des vues en coupe illustrant les étapes d'un exemple de procédé de fabrication d'une tranchée d'isolement.

En figure 4A, on a déposé une couche isolante 62 sur le substrat 2, par exemple par un dépôt de type CVD. A titre d'exemple, la couche 62 est en SiO₂ et a une épaisseur de l'ordre de 80 nm. On a ensuite réalisé une étape de photolithographie puis une étape de gravure de manière à former une tranchée 64 dans le substrat 2.

En figure 4B, on a déposé une couche isolante 66 de manière à remplir la tranchée 64. Le dépôt peut être un dépôt de type CVD. A titre d'exemple, la couche 66 est en dioxyde de silicium. En variante, on peut faire croître thermiquement du dioxyde de silicium sur les deux flancs latéraux et le fond du substrat 2 découverts suite à l'étape de gravure (décrite en relation avec la figure 4A). Cette croissance a pour but de guérir les défauts apparus après l'étape de gravure. A titre d'exemple, la couche issue de la croissance du SiO₂ a une épaisseur de l'ordre de 0.4 nm. On dépose ensuite par CVD du dioxyde de silicium pour remplir la tranchée 64. On peut ensuite avantageusement effectuer un recuit thermique pour densifier l'oxyde déposé.

En figure 4C, on a réalisé une étape de gravure mécano-chimique (en anglais CMP pour « Chemical Mechanical Polishing »). Cette étape de polissage s'est arrêtée dans la couche 62. On a ensuite effectué un retrait partiel de la couche 66 dans la tranchée 64 par un nettoyage par exemple à base d'acide fluorhydrique. La gravure humide de la couche 66 s'est arrêtée dans la tranchée 64. En variante, on peut prévoir d'arrêter la gravure de sorte que la surface supérieure de la couche 66 affleure sensiblement la surface de la face avant du substrat 2.

En figure 4D, on a déposé une couche isolante 68 sur la face avant du substrat 2. Ce dépôt est dit conforme et de type CVD ou ALD (pour « Atomic Layer Deposition »). La couche 68 comprend de l'azote ou du carbone. La couche 68 a une épaisseur de l'ordre de quelques nanomètres. On a ensuite déposé une couche isolante 70, par exemple par un dépôt de type CVD. La couche 70 est par exemple en SiO₂.

En figure 4E, on a réalisé une deuxième gravure mécano-chimique s'arrêtant dans la couche 62. La partie restante de la couche 68 forme une couche 72 d'encapsulation de la couche 66 disposée dans la tranchée. En périphérie de la couche 72 et sur sa portion supérieure, sont disposés deux éléments en saillie 72₁ et 72₂. Ces deux éléments, formant chacun une nervure, sont adjacents à la couche 62. On a ensuite gravé chimiquement, par exemple par de l'acide fluorhydrique et de l'acide phosphorique, la partie restante de la couche 70.

En figure 4F, on a gravé sélectivement le reste de la couche 62 disposée sur le substrat 2. On obtient alors une tranchée d'isolement 74 comportant une portion inférieure 66 en matériau isolant enterrée dans le substrat 2 et encapsulée par la portion supérieure constituée par la couche isolante 72 comprenant de l'azote ou du carbone. La présence des deux éléments en saillie 72₁ et 72₂ a pour effet de rallonger le parcours du lanthane ou du magnésium vers le réservoir d'oxygène constitué par la portion inférieure 66 de la tranchée d'isolement 74. Le phénomène de diffusion est donc limité.

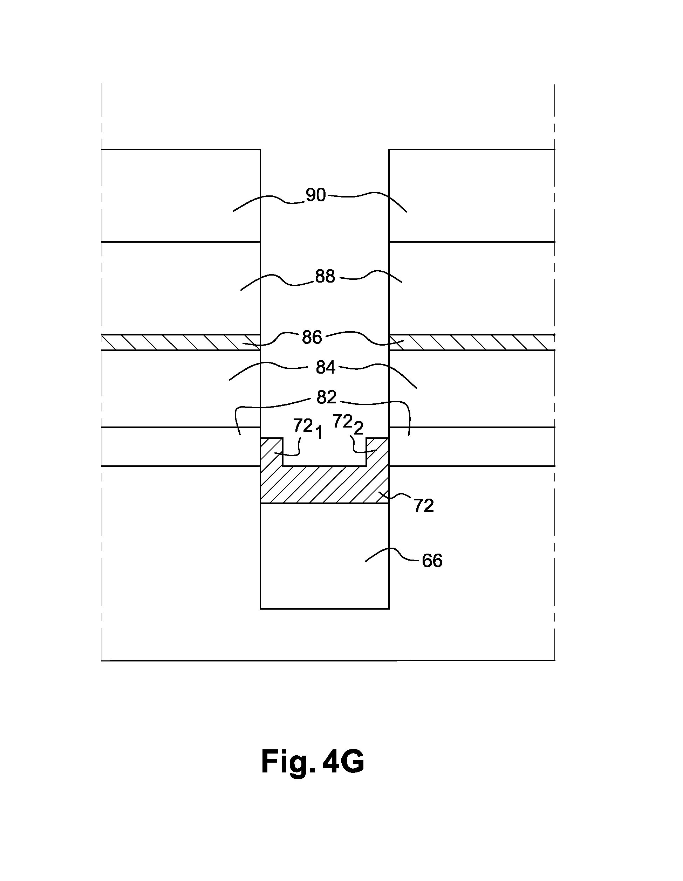

L'augmentation de la distance séparant la couche de lanthane ou magnésium du réservoir d'oxygène est visible sur la figure 4G. Sur cette figure, une tranchée d'isolement séparant deux transistors MOS distincts est représentée dans le plan BB. Les éléments en saillie 72₁ et 72₂ d'une tranchée pénètrent dans la couche isolante 82 d'un transistor MOS le long des bords de la tranchée.

A titre d'alternative, on peut prévoir de graver les deux éléments en saillie de la couche d'encapsulation de sorte que la surface supérieure de la couche 72 affleure sensiblement la surface supérieure du substrat 2.

En variante, on peut prévoir le dépôt ou la croissance d'une couche de dioxyde de silicium sur le substrat 2 avant le dépôt de la couche 62 qui peut alors être en SiN. En effet, l'étape de polissage de type CMP (prévue en figure 4C) s'arrête plus facilement dans une couche de SiN que dans une couche de SiO₂. De plus, la couche de SiO₂ protège le substrat en silicium lors de la gravure chimique (utilisant une solution à base de H₃PO₄) du SiN.

L'azote (ou le carbone) présent dans la couche 72 ralentit fortement l'absorption du lanthane ou du magnésium dans la portion inférieure 66 de la tranchée.

On peut alors procéder à la formation d'une grille isolée du substrat 2.

Les trois procédés de formation de la couche d'encapsulation de la portion inférieure de la tranchée sont avantageusement compatibles avec les procédés CMOS utilisés en microélectronique.

La figure 5 est une vue en coupe d'un circuit intégré.

Dans le substrat 2 est disposée la tranchée d'isolement 50. En variante, on peut prévoir de réaliser une tranchée d'isolement 40, 74 ou selon les différents modes de réalisation présentés ci-dessus. Sur la face avant 7 du substrat, à savoir sur la zone active délimitée par la tranchée est disposée une grille 80 d'un transistor MOS. La grille 80 est isolée du substrat par une couche isolante d'interface 82 comprenant de l'azote, par exemple en SiON. En variante, la couche 82 peut également comprendre une bi-couche comportant une couche en SiO₂ et une couche en SiON.

La grille comprend une couche diélectrique 84 à haute permittivité disposée sur la couche 82. A titre d'exemple non limitatif, la couche 84 est en oxyde d'hafnium, en silicate d'hafnium ou en oxyde de zirconium. Cette couche 84 est formée avantageusement par un dépôt de type ALD. Le matériau de la couche 84 est dit à haute permittivité, sa constante diélectrique étant supérieure à la constante diélectrique du SiON et du SiO₂. Sur la couche 84 est disposée une couche 86 en lanthane, en magnésium, en aluminium ou en dysprosium. Cette couche 86 est configurée pour ajuster le travail de sortie de la grille. A titre d'exemple, la couche 86 peut être formée par un dépôt de type PVD (acronyme anglais pour « Physical Vapour Deposition »). Pour ce faire, on utilise une cible en lanthane pur ou en La₂O₃. De la même manière, pour obtenir une couche 86 en magnésium, on utilise une cible en Mg ou en MgO. En variante, le dépôt peut être de type ALD.

La grille comprend également une couche métallique 88 déposée, par exemple, par un dépôt de type PVD. La couche 88 peut être en TiN, TaN ou en TaC. Enfin, la grille comprend une couche 90 en silicium polycristallin. Une portion de la couche 90 est destinée à être siliciurée. De part et d'autre de la grille 80 sont disposées des espaceurs 92, avantageusement en SiN. On réalise ensuite les zones de source et drain, de manière à obtenir un transistor MOS.

On obtient un transistor dont le contrôle de la tension de seuil est optimisé. En effet, les constituants de la couche 86 limite sa diffusion vers les réservoirs d'oxygène que sont les espaceurs 92, la couche d'interface 82 et les tranchées d'isolement 40, 50, 74.

Des modes de réalisation particuliers de la présente invention ont été décrits. Diverses variantes et modifications apparaîtront à l'homme de l'art. En particulier, on peut prévoir de réaliser une implantation ionique d'azote de la couche isolante 68. Le substrat 2 peut être un substrat de type SOI (acronyme pour Silicon On Insolator)

Divers modes de réalisation avec diverses variantes ont été décrits ci-dessus. On notera que l'homme de l'art pourra combiner divers éléments de ces divers modes de réalisation et variantes sans faire preuve d'activité inventive. En particulier, on peut combiner les procédés destinés à obtenir les dispositifs représentés aux figures 2, 3 et 4F.

## Revendications

1. Circuit intégré comprenant au moins une tranchée d'isolement (40 ; 50 ; 74) délimitant une zone active en matériau semi-conducteur monocristallin, comprenant en outre au moins une grille (80) de transistor MOS isolé de la zone active par une couche d'isolation de grille (82, 84), sur laquelle est disposée une couche (86) comprenant du lanthane, du magnésium, de l'aluminium ou du dysprosium, configurée pour ajuster le travail de sortie de la grille et une couche métallique (88), la ou chaque tranchée comprenant une portion supérieure (44 ; 54 ; 72) comportant une couche isolante d'encapsulation d'une portion inférieure (42 ; 52 ; 66) de la tranchée, la portion inférieure étant au moins en partie enterrée dans la zone active, la couche d'encapsulation comprenant de l'azote ou du carbone.

2. Circuit selon la revendication 1, dans lequel la couche d'encapsulation (42 ; 52 ; 66) comprend de l'oxynitrure de silicium ou du nitrure de silicium.

3. Circuit selon la revendication 1, dans lequel la couche d'encapsulation (42 ; 52 ; 66) comprend de l'oxycarbure de silicium ou du carbure de silicium.

4. Circuit selon l'une quelconque des revendications 1 à 3, dans lequel la couche d'encapsulation (72) comprend deux éléments en saillie (72₁, 72₂) disposés en périphérie de la couche.

5. Procédé de fabrication d'un circuit intégré dans un substrat semi-conducteur monocristallin (2), comprenant en outre au moins une grille (80) de transistor MOS isolé de la zone active par une couche d'isolation de grille (82, 84), sur laquelle est disposée une couche (86) comprenant du lanthane, du magnésium, de l'aluminium ou du dysprosium, configurée pour ajuster le travail de sortie de la grille et une couche métallique (88), comprenant les étapes suivantes :
- former dans le substrat au moins une portion inférieure (42 ; 52 ; 66) d'une tranchée d'isolement (40 ; 50 ; 74) délimitant une zone active (6);
- former une couche isolante d'encapsulation (44 ; 54 ; 72) comprenant de l'azote ou du carbone, la couche isolante définissant une portion supérieure de la tranchée d'isolement.

6. Procédé selon la revendication 5, comprenant en outre les étapes successives suivantes :
- former une couche d'isolation de grille (82, 84);
- former une couche (86) configurée pour ajuster le travail de sortie de la grille ;
- former une couche (88) en matériau conducteur ;

7. Procédé selon la revendication 6, comprenant en outre l'étape suivante :
- former des zones de source et de drain de part et d'autre de la grille (80).

8. Procédé selon l'une quelconque des revendications 5 à 7, dans lequel la couche isolante d'encapsulation (44) est formée suite aux étapes suivantes :
- déposer une couche comprenant de l'azote ou du carbone;
- réaliser une photolithographie ;
- réaliser une gravure partielle de la couche comprenant de l'azote ou du carbone.

9. Procédé selon l'une quelconque des revendications 5 à 8, dans lequel la couche isolante d'encapsulation (54) est formée suite à une étape d'implantation ionique d'azote ou de carbone.

10. Procédé selon l'une quelconque des revendications 5 à 8, dans lequel la formation de la couche isolante d'encapsulation (72) de la tranchée d'isolement (74) comprend les étapes suivantes :
- former la couche d'encapsulation par un dépôt conforme d'une couche comprenant de l'azote ou du carbone;
- former une couche isolante (70) par un dépôt sur la couche d'encapsulation ;
- graver entièrement la couche isolante et la couche d'encapsulation de sorte qu'une partie de la couche d'encapsulation recouvre la portion inférieure (66) de la tranchée.
